# EUROPEAN PATENT APPLICATION

(11) **EP 4 300 925 A1**
(43) Date of publication of application: **03.01.2024**
(21) Application number: 22776131.9
(22) Date of filing: 24.03.2022
(51) Int. Cl.: H04M 1/02, G06F 1/16, H05K 1/14, H05K 1/11, H05K 1/02

(54) **FLEXIBLE CONNECTION MEMBER AND ELECTRONIC DEVICE COMPRISING SAME**

(30) Priority: 24.03.2021 KR 20210038329
(71) Applicant: Samsung Electronics Co., Ltd., Suwon-si, Gyeonggi-do 16677 (KR)
(72) Inventor: BAE, Bumhee, Suwon-si, Gyeonggi-do 16677 (KR)
(74) Representative: Nederlandsch Octrooibureau
(86) International application number: PCT/KR2022/004168
(87) International publication number: WO 2022/203431

(57) **Abstract**

According to various embodiments of the present disclosure, provided is a foldable electronic device comprising: a hinge structure; a foldable housing including a folding area in which an electronic device is actually folded around a folding axis, the foldable housing including a first housing structure, which includes a first printed circuit board in which a plurality of electronic components are mounted, and a second housing structure, which is connected to the hinge structure, includes a second printed circuit board in which a plurality of electronic components are mounted and is folded with the first housing structure around the hinge structure; a flexible display; and a flexible connection member, which lies across at least a portion of the inside of the first housing structure and at least a portion of the inside of the second housing structure, electrically connects the first printed circuit board and the second printed circuit board through connective end portions arranged on both ends thereof, and includes a wiring for transmitting a communication signal including a radio frequency (RF) signal, wherein an impedance matching unit is mounted on at least one end of the connection member. Other various embodiments can be applied.

## Description

### [Technical Field]

Various embodiments of the disclosure relate to a flexible connection member having a matching unit for maintaining a constant total impedance of an RF line and an electronic device including the flexible connection member.

### [Background Art]

As electronic devices are highly integrated, and high-speed or high-volume wireless communication becomes commonplace, an electronic device, such as a mobile communication terminal, is recently being equipped with various functions. For example, an electronic device comes with the integrated functionality, including an entertainment function, such as playing video games, a multimedia function, such as replaying music/videos, a communication and security function for mobile banking, and a scheduling or e-wallet function. Further, to rid the user of any inconvenience in using multimedia services, a trend is to pack an electronic device with a larger display panel. Recently, flexible display panel-equipped foldable electronic devices come along. A foldable electronic device may refer to an electronic device including a plurality of housing structures that rotate relative to each other.

Meanwhile, circuit boards, as a component disposed in an electronic device, may be divided into rigid circuit boards and flexible circuit boards depending on the physical characteristics related to board flexibility. Recently, rigid-flexible circuit boards (hereinafter collectively referred to as 'flexible circuit boards'), in which rigid circuit boards and flexible circuit boards are combined, are also used to increase the reliability of electrical connection of electronic devices and implement three-dimensional solid lines.

To meet soaring wireless data traffic demand, 5G (next-generation) communication systems have been actively developed and deployed after commercialization of fourth generation (4G) communication systems. To achieve a high data rate, the 5G communication system uses ultra-high frequencies of several tens of GHz or more (or referred to as 'mmWave communication'). However, in electronic devices including an ultra-high frequency communication module, the performance of the communication module may be affected by the path (e.g., line) through which communication signals are transmitted due to high-frequency characteristics.

### [Detailed Description of the Invention]

### [Technical Problem]

An electronic device includes various electrical elements (or electronic components) and a printed circuit board on which the various electrical elements are mounted inside a bracket for mounting components. In a foldable electronic device, the electrical elements and the printed circuit board may be separately disposed in a plurality of housing structures considering various factors, such as space mountability, communication performance, and heat dissipation performance. In this case, to connect the electrical elements, a flexible circuit board that is easily bent may be used.

Flexible circuit boards are at least partially bendable, which can increase utilization in tight spaces and may be suitable for use in configurations that connect electrical elements contained within a housing structure to electrical elements contained within another housing structure, but may require additional consideration of durability and service life. In some embodiments, repetitive unfolding and folding at the hinge portion of a foldable electronic device may lead to stress accumulation in the bending portion of the flexible circuit board due to friction with a housing, component, or other substrate, damaging the electronic device. Further, the lifespan of the bending portion may be shortened due to repeated use of the foldable electronic device.

When a foldable electronic device is provided with an ultra-high frequency communication module (e.g., ultra-high frequency communication of 6 GHz or more and less than 100 GHz) (e.g., when a flexible circuit board including an RF signal line is included), the flexible circuit board designed considering RF characteristics may have a narrower width than the board having general signal lines. This causes a change in impedance of the flexible circuit board including the RF signal line, resulting in deterioration of RF characteristics, e.g., increased loss.

According to various embodiments of the disclosure, there may be provided a foldable electronic device that prevents loss by maintaining the impedance of the foldable electronic device.

### [Technical Solution]

According to various embodiments of the disclosure, there may be provided a foldable electronic device, comprising a hinge structure, a foldable housing including a folding area where the electronic device is substantially folded about a folding axis. The foldable housing includes a first housing structure connected to the hinge structure and including a first surface facing in a first direction, a second surface facing in a second direction opposite to the first direction, and a first printed circuit board where a plurality of electronic components are mounted and a second housing structure connected to the hinge structure, including a third surface facing in a third direction, a fourth surface facing in a fourth direction opposite to the third direction, and a second printed circuit board where a plurality of electronic components are mounted, and configured to be folded with the first housing structure about the hinge structure, a flexible display disposed in the foldable housing and extending from the first surface of the first housing structure to the third surface of the second housing structure, and a flexible connection member lying across at least a portion of an inside of the first housing structure, electrically connecting the first printed circuit board and the second printed circuit board through connection ends disposed at two opposite ends thereof, and including an electrical line configured to transmit a communication signal including a radio frequency (RF) signal, wherein an impedance matching part is mounted at at least one end of the flexible connection member.

### [Advantageous Effects]

According to an embodiment of the disclosure, even when the impedance of the bent portion of the flexible connection member changes, the overall impedance may be maintained constant by the impedance matching part provided at the end of the flexible connection member. Accordingly, it is possible to prevent deterioration of RF characteristics, e.g., an increase in loss, due to a change in impedance.

### [Brief Description of Drawings]

FIG. 1 is a view illustrating an electronic device in a network environment according to an embodiment;
FIG. 2 is a view illustrating an unfolded state of an electronic device according to various embodiments of the disclosure;
FIG. 3A is a view illustrating a fully unfolded state of a display part of an electronic device, according to an embodiment;
FIG. 3B is a cross-sectional view illustrating an intermediate state in which a display part of an electronic device is partially unfolded, according to an embodiment;
FIG. 4 is an exploded perspective view illustrating an electronic device according to various embodiments of the disclosure;
FIG. 5 is a view illustrating a portion of an inside of an electronic device according to various embodiments of the disclosure;
FIG. 6 is a view illustrating flexible connection members according to various embodiments of the disclosure;
FIG. 7 is a cross-sectional view illustrating a flexible connection member according to an embodiment of the disclosure; and
FIG. 8 is a cross-sectional view illustrating a flexible connection member according to other embodiments of the disclosure.

### [Mode for Carrying out the Invention]

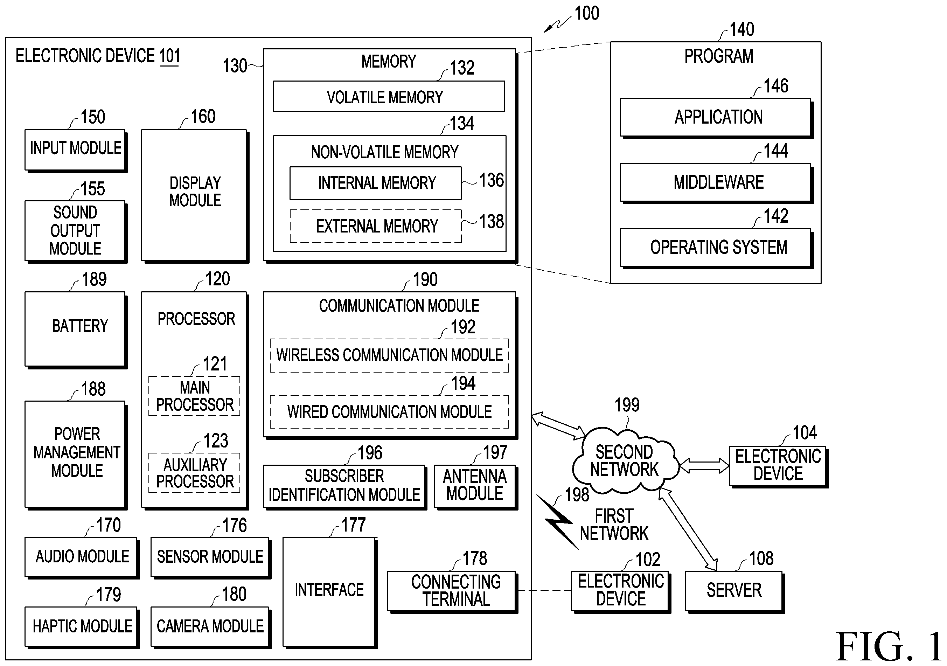

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In an embodiment, at least one (e.g., the connecting terminal 178) of the components may be omitted from the electronic device 101, or one or more other components may be added in the electronic device 101. According to an embodiment, some (e.g., the sensor module 176, the camera module 180, or the antenna module 197) of the components may be integrated into a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be configured to use lower power than the main processor 121 or to be specified for a designated function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. The artificial intelligence model may be generated via machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by other component (e.g., the processor 120) of the electronic device 101, from the outside (e.g., a user) of the electronic device 101. The input module 150 may include, for example, a microphone, a mouse, a keyboard, keys (e.g., buttons), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display 160 may include, for example, a display, a hologram device, or a projector and control circuitry to control a corresponding one of the display, hologram device, and projector. According to an embodiment, the display 160 may include a touch sensor configured to detect a touch, or a pressure sensor configured to measure the intensity of a force generated by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an accelerometer, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or motion) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device 104 via a first network 198 (e.g., a short-range communication network, such as Bluetooth^{™}, wireless-fidelity (Wi-Fi) direct, or infrared data association (IrDA)) or a second network 199 (e.g., a long-range communication network, such as a legacy cellular network, a 5G network, a next-generation communication network, the Internet, or a computer network (e.g., local area network (LAN) or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device). According to an embodiment, the antenna module 197 may include one antenna including a radiator formed of a conductive body or conductive pattern formed on a substrate (e.g., a printed circuit board (PCB)). According to an embodiment, the antenna module 197 may include a plurality of antennas (e.g., an antenna array). In this case, at least one antenna appropriate for a communication scheme used in a communication network, such as the first network 198 or the second network 199, may be selected from the plurality of antennas by, e.g., the communication module 190. The signal or the power may then be transmitted or received between the communication module 190 and the external electronic device via the selected at least one antenna. According to an embodiment, other parts (e.g., radio frequency integrated circuit (RFIC)) than the radiator may be further formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. The external electronic devices 102 or 104 each may be a device of the same or a different type from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an Internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or health-care) based on 5G communication technology or IoT-related technology.

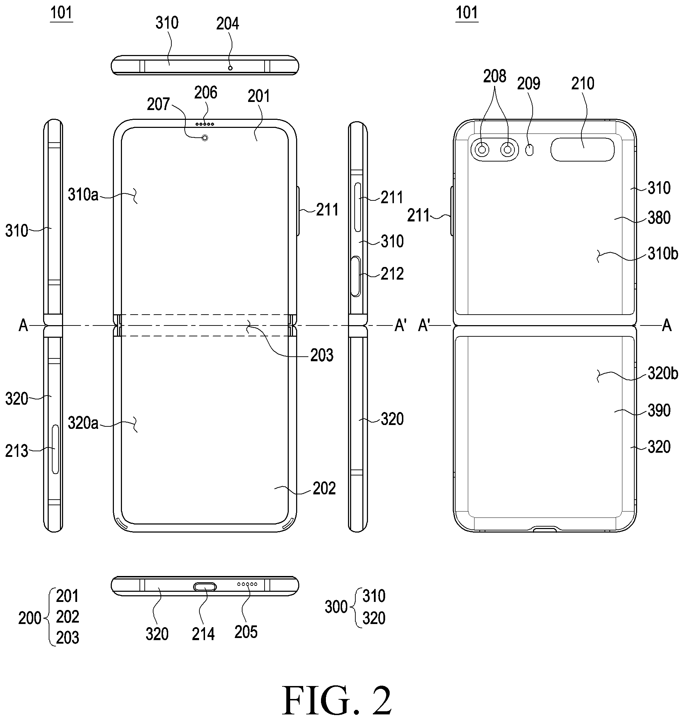

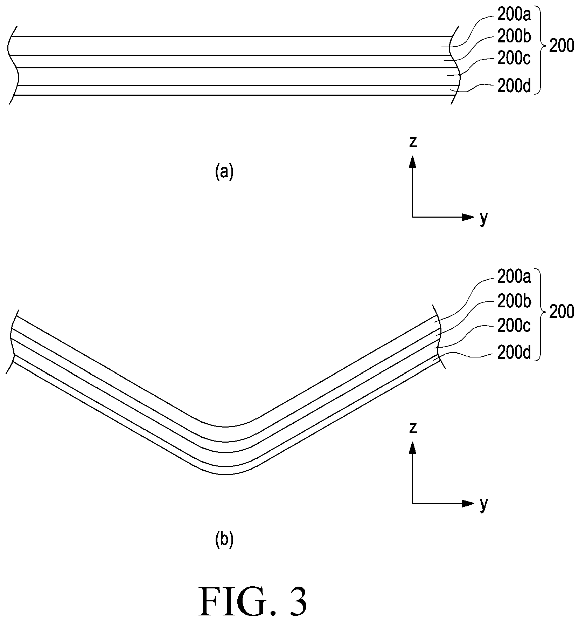

FIG. 2 is a view illustrating an unfolded state of an electronic device 101 according to various embodiments of the disclosure. FIG. 2 illustrates various views of the front, back, and side of the electronic device 101 together. FIG. 3A is a view illustrating a fully unfolded state of a display part of an electronic device 101, according to an embodiment. FIG. 3B is a cross-sectional view illustrating an intermediate state in which a display part of an electronic device 101 is partially unfolded, according to an embodiment.

Referring to FIG. 2, according to an embodiment, an electronic device 101 may include a foldable housing 300 and a flexible or foldable display 200 (hereinafter, simply "display 200") (e.g., the display device 160 of FIG. 1) disposed in a space formed by the foldable housing 300.

According to an embodiment, the surface on which the display 200 is disposed may be defined as a front surface of the electronic device 101. At least a portion of the front surface of the electronic device 101 may be formed of a substantially transparent front plate (e.g., a glass plate or polymer plate including various coat layers). The opposite surface of the front surface may be defined as a rear surface of the electronic device 101. The rear surface of the electronic device 101 may be formed by a substantially opaque rear plate (hereinafter, referred to as a 'rear cover'). The rear cover may be formed of, e.g., laminated or colored glass, ceramic, polymer, metal (e.g., aluminum, stainless steel (STS), or magnesium), or a combination of at least two thereof. The surface surrounding the space between the front and back surfaces may be defined as a side surface of the electronic device 101. The side surface may be formed by a side bezel structure (or a "side member") that couples to the front plate and the rear plate and includes a metal and/or polymer. According to an embodiment, the rear cover and the side bezel plate may be integrally formed together and include the same material (e.g., a metal, such as aluminum).

The electronic device 101 may include at least one or more of a display 200, audio modules 204, 205, and 206, a sensor module 209, camera modules 207 and 208, key input devices 211, 212, and 213, and a connector hole 214. According to an embodiment, the electronic device 101 may omit at least one (e.g., the key input devices 211, 212, and 213) of the components or additionally include another component (e.g., a light emitting device).

According to various embodiments, the display 200 may be a display at least a portion of which may be transformed into a flat or curved surface. According to an embodiment, the display 200 may include a folding area 203, a first area 201 disposed on one side of the folding area 203 (e.g., the upper side of the folding area 203 of FIG. 2), and a second area 202 disposed on the opposite side of the folding area 203 (e.g., the lower side of the folding area 203 of FIG. 2). However, the segmentation of the display 200 as shown in FIG. 2 is merely an example, and the display 200 may be divided into a plurality of (e.g., four or more, or two) areas depending on the structure or function of the display 200. For example, in the embodiment illustrated in FIG. 2, the display 200 may be divided into the areas by the folding area 203 or folding axis A-A' but, in another embodiment, the display 200 may be divided into the areas with respect to another folding area or another folding axis (e.g., a folding axis perpendicular to the folding axis A-A').

According to various embodiments, the audio modules 204, 205, and 206 may include a microphone hole 204 and speaker holes 205 and 206. A microphone for acquiring external sounds may be disposed in the microphone hole 204. In some embodiments, a plurality of microphones may be disposed to detect the direction of the sound. The speaker holes 205 and 206 may include an external speaker hole 205 and a phone receiver hole 206. According to an embodiment, the speaker holes 205 and 206 and the microphone hole 204 may be implemented as a single hole, or speakers may be rested without the speaker holes 205 and 206 (e.g., piezo speakers). Various changes may be made to the position and number of microphone holes 204 and speaker holes 205 and 206 according to an embodiment.

According to various embodiments, the camera modules 207 and 208 may include a first camera device 207 disposed on the first surface 310a of the first housing structure 310 of the electronic device 101 and a second camera device 208 disposed on the second surface 310b. The electronic device 101 may further include a flash (not shown). The camera devices 207 and 208 may include one or more lenses, an image sensor, and/or an image signal processor. The flash (not shown) may include, e.g., a light emitting diode (LED) or a xenon lamp.

According to various embodiments, the sensor modules 209 may generate an electrical signal or data value corresponding to an internal operating state or external environmental state of the electronic device 101. Although not shown in the drawings, the electronic device 101 may additionally or alternatively include a sensor module other than the sensor module 209 provided on the second surface 310b of the first housing structure 310. The electronic device 101 may include, as the sensor module, at least one of a proximity sensor, a fingerprint sensor, an HRM sensor, a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or an illuminance sensor.

According to various embodiments, the key input devices 211, 212, and 213 may be disposed on a side surface of the foldable housing 300. According to another embodiment, the electronic device 101 may exclude all or some of the above-mentioned key input devices 211, 212, and 213 and the excluded key input devices may be implemented in other forms, e.g., as soft keys, on the display 200. In some embodiments, the key input device may be configured to implement key input by a sensor module.

According to various embodiments, the connector hole 214 may be configured to receive a connector (e.g., a USB connector) for transmitting/receiving power and/or data to/from an external electronic device or, additionally or alternatively, a connector for transmitting/receiving audio signals to/from an external electronic device.

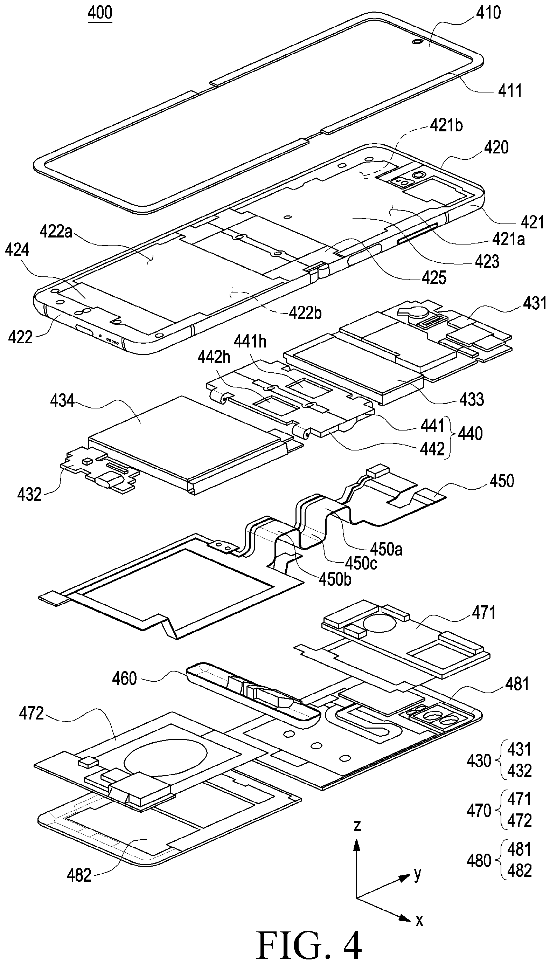

According to various embodiments, the foldable housing 300 may include a first housing structure 310, a second housing structure 320, a first rear cover 380, a second rear cover 390, and a hinge structure. (e.g., the hinge structure 440 of FIG. 4 to be described below). The foldable housing 300 of the electronic device 101 are not limited to the shape and coupling shown in FIGS. 2 and 3 but may rather be implemented in other shapes or via a combination and/or coupling of other components. For example, in another embodiment, the first housing structure 310 and the first rear cover 380 may be integrally formed with each other, and the second housing structure 320 and the second rear cover 390 may be integrally formed with each other. According to various embodiments of the disclosure, `housing structure' may be a component obtained by combining and/or coupling various components, including the housing.

According to various embodiments, the first housing structure 310 may be connected to the hinge structure (e.g., the hinge structure 440 of FIG. 4 described below) and may include a first surface 310a facing in a first direction and a second surface 310b facing in a second direction opposite to the first direction. The second housing 320 may be connected to the hinge structure (e.g., the hinge structure 440 of FIG. 4 described below) and may include a third surface 320a facing in a third direction and a fourth surface 320b facing in a fourth direction opposite to the third direction and may be rotated from the first housing 310 about the hinge structure (or folding axis A-A').

According to various embodiments, the first housing structure 310 and the second housing structure 320 may be disposed on both sides (or upper/lower sides) of the folding axis A-A', and may have an overall symmetrical shape with respect to the folding axis A-A'. The angle or distance between the first housing structure 310 and the second housing structure 320 may be varied depending on whether the electronic device 101 is in the unfolded state, the folded state, or the partially unfolded (or partially folded) intermediate state. According to an embodiment, the first housing structure 310 may further include various sensors unlike the second housing structure 320 but, in the remaining area, the first housing 210 and the second housing 220 may have symmetrical shapes with each other.

According to various embodiments, at least a portion of the first housing structure 310 and the second housing structure 320 may be formed of a metal or a non-metal material having a predetermined degree of rigidity to support the display 200. At least a portion formed of metal may provide a ground plane of the electronic device 101 and may be electrically connected with a ground line formed on a printed circuit board (e.g., the printed circuit board 430 of FIG. 4).

According to various embodiments, the first rear cover 380 may be disposed on one side of the folding axis A-A' on the rear surface of the electronic device 101 and have, e.g., a substantially rectangular periphery which may be surrounded by the first housing structure 310. Similarly, the second rear cover 390 may be disposed on the opposite side of the folding axis A-A' on the rear surface of the electronic device 101 and its periphery may be surrounded by the second housing structure 320.

According to various embodiments, the first rear cover 380 and the second rear cover 390 may be substantially symmetrical in shape with respect to the folding axis A-A'. However, the first rear cover 380 and the second rear cover 390 are not necessarily symmetrical in shape. In another embodiment, the electronic device 101 may include the first rear cover 380 and the second rear cover 390 in various shapes. In another embodiment, the first rear cover 380 may be integrally formed with the first housing structure 310, and the second rear cover 390 may be integrally formed with the second housing structure 320.

According to various embodiments, the first rear cover 380, the second rear cover 390, the first housing structure 310, and the second housing structure 320 may form a space where various components (e.g., a printed circuit board or battery) of the electronic device 101 may be disposed. According to an embodiment, one or more components may be arranged or visually exposed on/through the rear surface of the electronic device 101. For example, at least a portion of a sub display 210 may be visually exposed through the first rear cover 380. In another embodiment, one or more components or sensors may be visually exposed through the first rear cover 380. According to various embodiments, the sensor may include a proximity sensor and/or a rear-facing camera. Although not separately shown in the drawings, one or more other components or sensors may be visually exposed through the second rear cover 390.

According to various embodiments, the front camera 207 exposed from the front surface of the electronic device 101 through one or more openings or the rear camera 208 exposed through the first rear cover 380 may include one or more lenses, an image sensor, and/or an image signal processor. The flash 209 may include, e.g., a light emitting diode (LED) or a xenon lamp. In an embodiment, two or more lenses (an infrared (IR) camera, a wide-angle lens, and a telephoto lens) and image sensors may be disposed on one surface of the electronic device 101.

Referring to FIG. 3, the display 200 according to various embodiments is described in greater detail.

According to various embodiments, (a) of FIG. 3 may show a fully unfolded state of the display part, and (b) of FIG. 3 may show a partially unfolded state (or partially folded state) of the display part.

According to various embodiments, the display part of the electronic device 101 may include a component that displays a screen through a display and a component that is connected to the display and moves integrally with the display. Referring to (a) of FIG. 3, the display part may include a display panel 200c and a touch panel 200d disposed adjacent to the display panel 200c.

The electronic device 101 may transform to a folded status or an unfolded status. The electronic device 101 may be folded in two types, e.g., 'in-folding' in which it is folded so that the front surface of the electronic device 101 forms an acute angle and 'out-folding' in which it is folded so that the front surface of the electronic device 101 forms an obtuse angle, as viewed in the direction of the folding axis (e.g., A-A' of FIG. 2). For example, in the in-folded state of the electronic device 101, the first surface 310a may face the third surface 320a and, in the fully unfolded state, the third direction may be identical to the first direction. As another example, in the out-folded state of the electronic device 101, the second surface 310b may face the fourth surface 320b.

The in-folding type may mean a state in which the display 200 is not exposed to the outside in the fully folded state. The out-folding type may mean a state in which the display 200 is exposed to the outside in the fully folded state, (b) of FIG. 3 illustrates an intermediate status in which the electronic device 101 is partially unfolded during in-folding. Although the in-folded state of the electronic device 101 is described below for convenience purposes, it should be noted that the descriptions may also apply to the out-folded state of the electronic device 101.

According to an embodiment, the display 200 may include a display panel 200c, a polarization layer 200b disposed on the display panel 200c, and a window member 200a forming the appearance of the display. The display panel 200c, the polarization layer 200b, and the window member 200a form one display 200 and may be formed of a flexible material. Accordingly, as shown in (a) of FIG. 3, when an external force is applied in a state in which the display 200 is unfolded, the display 200 may be bent as shown in (b) of FIG. 3. Alternatively, as shown in (b) of FIG. 3, when an external force is applied in a partially folded state, the display 200 may be unfolded as shown in (a) of FIG. 3.

According to various embodiments, the electronic device 101 may detect an input (e.g., the user's input or an input through the input device 150 of FIG. 1) on the surface of the display 200 by the touch panel 200d. Here, the input recognizable by the touch panel 200d may include not only an input through direct contact with the surface of the display 200, but also an input through hovering. According to an embodiment, the touch panel 200d may have substantially the same area as the display 200. According to various embodiments, the touch panel 200d may be disposed on the upper surface or the rear surface of the display 200. As an embodiment, FIG. 3 illustrates a state in which the touch panel 200d is attached to the rear surface of the display 200.

According to an embodiment, the display 200 may, at least partially, be formed of a material that transmits radio waves or magnetic fields. Since the display panel 200c and/or the touch panel 200d may be equipped in the display 200, the display 200 may be used as an input device having touchscreen functionality as well as an output device that outputs a screen. The display panel 200c may include a display element layer including at least one pixel(s) and a TFT layer connected to the display element layer. According to various embodiments, the display panel 200c may be a panel, such as of liquid crystal display (LCD), light emitting diode (LED), or organic light emitting diode (OLED), and display various images according to various operation states of the electronic device 101 and execution of the application, and contents.

According to various embodiments, as the touch panel 200d, touch panels in various schemes may be included. For example, touch panels in various schemes, such as a capacitive touch panel that detects changes in capacitance, a resistive touch panel that detects the position by detecting the pressure on the panel, an optical touch panel using infrared rays, and a transparent electrode type touch panel that uses contact points of a transparent conductive film, may be used. Other input position detection panels not mentioned, such as a touch panel in an electromagnetic resonance scheme, may be used.

According to various embodiments, the window member 200a may serve as a protection film for protecting the display panel 200c. As a protection film, the window member 200a may be formed of a material that protects the display panel 200c from external impact, is robust against scratches, and causes fewer creases in the folding area when the foldable housing is repeatedly folded and unfolded. For example, the material of the window member 200a may include a clear polyimide (CPI) film or ultra-thin glass (UTG).

FIG. 4 is an exploded perspective view illustrating an electronic device 400 (e.g., the electronic device 101 of FIG. 1) according to various embodiments of the disclosure.

Referring to FIG. 4, according to various embodiments, an electronic device 400 may include a display 410 (e.g., the display 200 of FIG. 2), a foldable housing 420 (e.g., the foldable housing 300 of FIG. 2), a printed circuit board 430, a hinge structure 440, a flexible connection member 450, a hinge cover 460, an antenna module 470, and a rear cover 480. Hereinafter, detailed descriptions of the components overlapping those of FIGS. 2 and 3 (e.g., the display 410, the foldable housing 420, and the rear cover 480) will be omitted.

According to various embodiments, the display 410 may be exposed through a majority portion of the front plate 411. According to an embodiment, the shape of the display 410 may be formed to be substantially the same as the shape of the periphery of the front plate 411.

According to various embodiments, the foldable housing 420 may include a first housing 421 and a second housing 422. According to an embodiment, the first housing 421 may include a first surface 421a and a second surface 421b facing in a direction opposite to the first surface 421a. The second housing 422 may include a third surface 422a and a fourth surface 422b facing in a direction opposite to the third surface 422a. The foldable housing 420 may additionally or alternatively include a bracket assembly. The bracket assembly may include a first bracket assembly 423 disposed in the first housing 421 and a second bracket assembly 424 disposed in the second housing 422. At least part of the bracket assemblies, e.g., a portion 425 including at least part of the first bracket assembly 423 and at least part of the second bracket assembly 424, may serve as a plate for supporting the housing structure 440.

According to various embodiments, various electric components may be disposed on the printed circuit board 430. For example, a processor (e.g., the processor 120 of FIG. 1), a memory (e.g., the memory 130 of FIG. 1), and/or an interface (e.g., the interface 177 of FIG. 1) may be mounted on the printed circuit board 430. The processor may include one or more of, e.g., a central processing unit, an application processor, a graphic processing device, an image signal processing, a sensor hub processor, or a communication processor. The memory may include, e.g., a volatile or non-volatile memory. The interface may include, e.g., a high definition multimedia interface (HDMI), a universal serial bus (USB) interface, a secure digital (SD) card interface, and/or an audio interface. The interface may electrically or physically connect, e.g., the electronic device 101 with an external electronic device and may include a USB connector, an SD card/multimedia card (MMC) connector, or an audio connector.

According to various embodiments, the printed circuit board 430 may include a first printed circuit board 431 disposed on the side of the first bracket assembly 423 and a second printed circuit board 432 disposed on the side of the second bracket assembly 424. The first printed circuit board 431 and the second printed circuit board 432 may be disposed inside the space formed by the foldable housing 420, bracket assemblies, first rear cover 481 and/or second rear cover 482. Components for implementing various functions of the electronic device 400 may be separately disposed on the first printed circuit board 431 and the second printed circuit board 432. For example, a processor may be disposed on the first printed circuit board 431, and an audio interface may be disposed on the second printed circuit board 432.

According to various embodiments, a battery may be disposed adjacent to the printed circuit board 430 to supply power to the electronic device 400. At least a portion of the battery may be disposed on substantially the same plane as the printed circuit board 430. According to an embodiment, a first battery 433 may be disposed adjacent to the first printed circuit board 431, and a second battery 434 may be disposed adjacent to the second printed circuit board 432. The battery may be a device for supplying power to at least one component of the electronic device 400. The battery 189 may include, e.g., a primary cell which is not rechargeable, a secondary cell which is rechargeable, or a fuel cell. The battery may be integrally disposed in the electronic device 400 or be detachably disposed to the electronic device 400. According to various embodiments, the hinge structure 440 may be a component for supporting the foldable housing 420 and/or bracket assembly to allow the foldable housing 420 to rotate about the folding axis (e.g., A-A' of FIG. 2). The hinge structure 440 may include a first hinge structure 441 disposed on the side of the first printed circuit board 431 and a second hinge structure 442 disposed on the side of the second printed circuit board 432. The hinge structure 440 may be disposed between the first printed circuit board 431 and the second printed circuit board 432. According to an embodiment, the hinge structure 440 may be formed substantially integrally with the portion 425 including at least a portion of the first bracket assembly 423 and at least a portion of the second bracket assembly 424.

According to various embodiments, a 'housing structure' may include the foldable housing 420 and may be one resultant from assembling and/or combining at least one component disposed in the housing 420. The housing structure may include a first housing structure and a second housing structure. For example, a component assembled to include the first housing 421 and further include at least one component among the first bracket assembly 423, the first printed circuit board 431, and the first battery 433 disposed inside the first housing 421 may be referred to as the 'first housing structure.' As another example, a component assembled to include the second housing 422 and further include at least one component among the second bracket assembly 424, the second printed circuit board 432, and the second battery 434 disposed inside the second housing 422 may be referred to as the 'second housing structure.' However, it should be noted that the 'first housing structure and the second housing structure' are not limited to the addition of the above-described components, but may add or omit various other components.

According to various embodiments, the flexible connection member 450 may be, e.g., a flexible printed circuit board (FPCB) and electrically connect various electrical elements disposed on the first printed circuit board 431 and the second printed circuit board 432. To this end, the flexible connection member 450 may be disposed to cross the 'first housing structure' and the 'second housing structure'. According to an embodiment, the flexible connection member 450 may be formed to at least partially hang over the hinge structure 440. According to an embodiment, the flexible connection member 450 may be configured to cross the hinge structure 440, e.g., in a direction parallel to the y-axis of FIG. 4 to connect the first printed circuit board 431 and the second printed circuit board 432. As another example, the flexible connection member 450 may be fitted into the openings 441h and 442h formed in the hinge structure 440. In this case, a portion 450a of the flexible connection member 450 may be disposed over one side (e.g., upper portion) of the first hinge structure 441, and another portion 450b of the flexible connection member 450 may be disposed over one side (e.g., upper portion) of the second hinge structure 442. Another portion 450c of the flexible connection member 450 may be disposed on the other side (e.g., lower portion) of the first hinge structure 441 and the second hinge structure 442. A space (hereinafter, referred to as a `hinge space') surrounded by at least a portion of the first hinge structure 441, at least a portion of the second hinge structure 442, and at least a portion of the hinge cover 460 may be formed in a position adjacent to the first hinge structure 441 and the second hinge structure 442. According to an embodiment, at least a portion 450c of the flexible connection member 450 may be disposed in the hinge space.

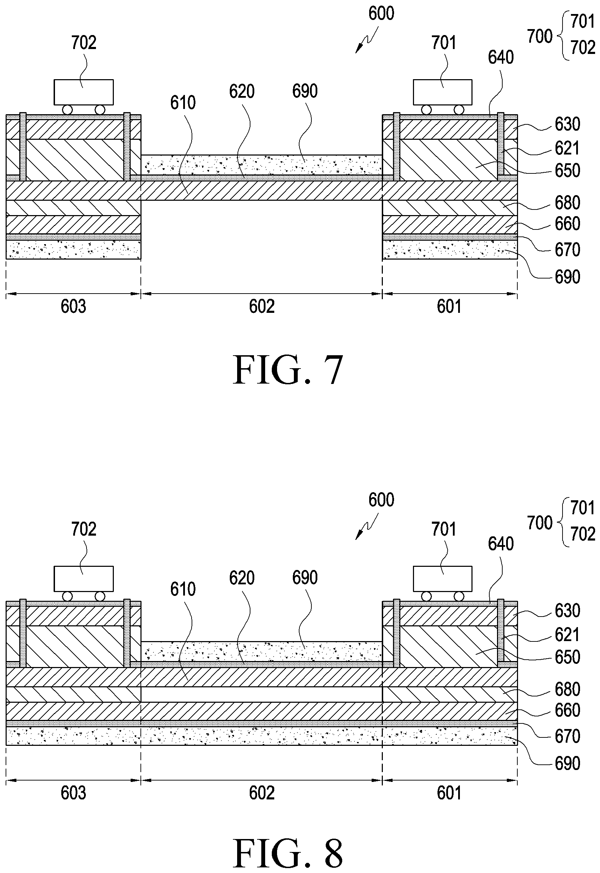

According to various embodiments, the hinge cover 460 may be a component that covers at least a portion of the hinge space. The hinge cover 460, together with the hinge structure 440, may close the hinge space and protect a component (e.g., at least a portion 450c of the flexible connection member 450) disposed in the hinge space from external impact. According to an embodiment, the hinge cover 460 may be disposed between the first housing 421 and the second housing 422. According to an embodiment, the hinge cover 460 may be coupled to each of at least a portion (e.g., the first rotation support 511 of FIG. 7 to be described below) of the first housing and at least a portion (e.g., the first rotation support 521 of FIG. 7 to be described below) of the second housing.

According to various embodiments, the antenna module 470 (e.g., the antenna module 197 of FIG. 1) may be disposed between the rear cover 480 and the battery. The antenna module 470 may include a plurality of antenna modules in one electronic device 400. For example, the antenna module 470 may include a first antenna module 471 disposed on the side of the first housing 421 and a second antenna module 472 disposed on the side of the second housing 422. The antenna module may include at least one radiator. Further, the antenna module 470 may include, e.g., a near field communication (NFC) antenna, a wireless charging antenna, and/or a magnetic secure transmission (MST) antenna. The antenna module 470 may perform short-range communication with an external device or wirelessly transmit/receive power required for charging. According to another embodiment, an antenna structure may be formed by a portion or combination of the side bezel structure of the foldable housing 420 and/or bracket assembly.

According to various embodiments, the rear cover 480 may include a first rear cover 481 and a second rear cover 482. The rear cover 480 may be combined with the foldable housing 420 to protect the above-described components (e.g., the printed circuit board 430, the battery, the flexible connection member 450, and the antenna module 470) disposed in the foldable housing 420. As described above, the rear cover 480 may be configured substantially integrally with the foldable housing 420.

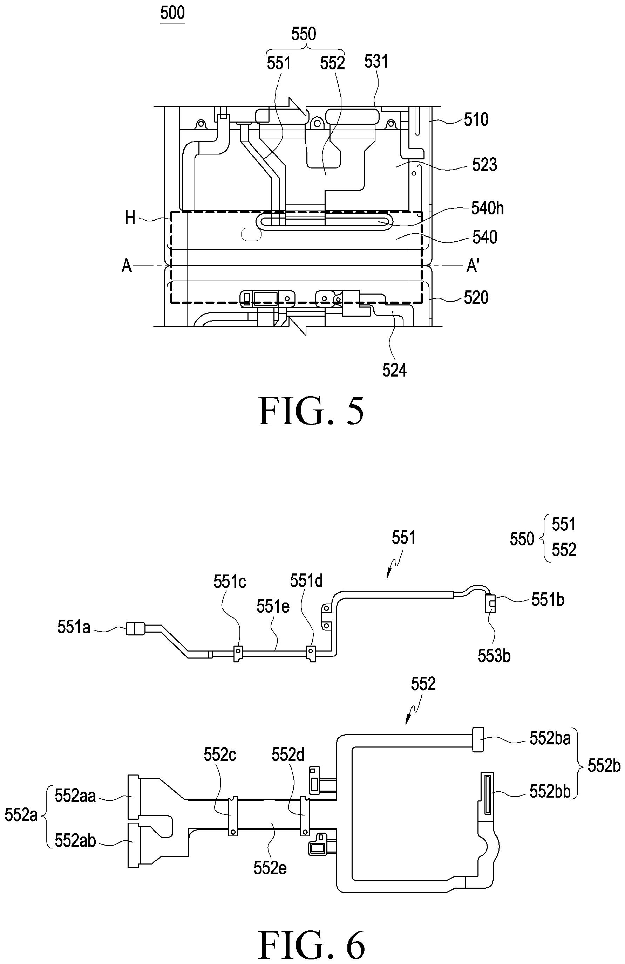

FIG. 5 is a view illustrating a portion of an inside of an electronic device (e.g., the electronic device 101 of FIG. 2) according to various embodiments of the disclosure.

Referring to FIG. 5, the foldable housing 501 (e.g., the foldable housing 420 of FIG. 4) may include a first housing 510 and a second housing 520. Here, the first housing 510 (e.g., the first housing 410 of FIG. 4) and the second housing 520 (e.g., the second housing 420 of FIG. 4) may be cover portions surrounding the first housing structure (e.g., the first housing structure 310 of FIG. 2) and the second housing structure (e.g., the second housing structure 320 of FIG. 2), respectively.

Referring to FIG. 5, the flexible connection member 550 may lie across at least a portion of the inside of the first housing structure (e.g., the first housing structure 310 of FIG. 2) and at least a portion of the inside of the second housing structure (e.g., the second housing structure 320 of FIG. 2). Here, when the flexible connection member 550 "lies across" inside the housing structure, it may mean that the flexible connection member 550 having a relatively long extended shape is disposed above or below the housing structure (or components inside the housing structure). As described above, the housing structure may include a housing, and may be the structure assembled to further include at least one of the bracket assembly, the printed circuit board, and the battery disposed inside the housing. Accordingly, that the flexible connection member 550 lies across at least a portion of the inside of the housing structure may be interpreted as the flexible connection member 550 lying across at least some of the components included in the housing structure. For example, the flexible connection member 550 may lie across at least a portion of the first bracket assembly 523 (e.g., the first bracket assembly 423 of FIG. 4) and at least a portion of the second bracket assembly 524 (e.g., the second bracket assembly 424 of FIG. 4).

As illustrated in FIG. 5, when the inside of the foldable housing 501 is viewed from above, at least a portion of the flexible connection member 550 may be covered by the hinge structure 540. The portion H covered by the hinge structure 540 may be a portion disposed in a hinge space. Further, the portion H covered by the hinge structure 540 may be a portion in which movement (or bending) occurs repeatedly in the flexible connection member 550 during unfolding and folding of the foldable electronic device, i.e., a bending portion. The bending portion of the flexible connection member 550 may be damaged due to accumulated stress caused by friction with the housing, components, or other substrates. Although the width and thickness of the bending portion of the flexible connection member 550 may be adjusted to prevent the bending portion from being damaged, it may be difficult to match the impedance when the width and thickness of the bending portion are changed.

According to various embodiments, the flexible connection member 550 included in the foldable electronic device may include a plurality of flexible connection members 551 and 552. According to an embodiment, at least a portion of the flexible connection member 550 may lie across inside the first housing structure including the first housing 510, the first bracket assembly 523, and the first printed circuit board 531, and another portion may lie across inside the second housing structure including the second housing 520 and the second bracket assembly 524. For reference, the second printed circuit board may be omitted in FIG. 5. The flexible connection member 550 may lie across the first housing structure and the second housing structure across the hinge structure 540. In this case, a portion of the flexible connection member 550 may be configured to pass through the opening 540h formed in the hinge structure 540.

FIG. 6 is a view illustrating a flexible connection member 550 according to various embodiments of the disclosure.

Referring to FIG. 6, according to various embodiments of the disclosure, the flexible connection member 550 may include a plurality of flexible connection members. For example, the flexible connection member 550 may include a first flexible connection member 551 and a second flexible connection member 552. Further, although not illustrated in the drawings, the flexible connection member 550 may further include a third flexible connection member (not illustrated) or other flexible connection members.

In the embodiment of FIG. 6, the first flexible connection member 551 and the second flexible connection member 552 may be disclosed as two flexible connection members completely separated from each other.

As another example, unlike this, substantially one flexible connection member may be divided into a first flexible connection member 551 and a second flexible connection member 552. For example, substantially one flexible connection member that is not physically divided may be divided into a first flexible connection member 551 and a second flexible connection member 552 according to the type of signal line, or may be partially branched into two or more branches only in a partial area of the area in which the flexible connection member is located. For example, although not illustrated in the drawings, the first flexible connection member 551 and the second flexible connection member 552 may have an integrated flexible connection member form inside the first housing structure (e.g., the first housing structure 310 of FIG. 2), and may have a form branched into two different flexible connection members 551 and 552 inside the second housing structure (e.g., the second housing structure 320 of FIG. 2). It should be noted that the shape of the flexible connection member may vary depending on embodiments. For convenience of description, the following description focuses primarily on two flexible connection members 551 and 552 that are physically spaced apart from each other and have different shapes, but it should be noted that the scope of the disclosure is not necessarily limited thereto.

Referring back to FIG. 6, the first flexible connection member 551 may lie across at least a portion of the inside of the first housing structure (e.g., the first housing structure 310 of FIG. 2) and at least a portion of the second housing structure (e.g., the second housing structure 320 of FIG. 2). The second flexible connection member 552 may also lie across at least the portion of the first housing structure (e.g., the first housing structure 310 of FIG. 2) and at least the portion of the second housing structure (e.g., the second housing structure 520 of FIG. 2).

According to various embodiments, the first and second flexible connection members 551 and 552 may include means for being connected to at least one of the first printed circuit board (e.g., the first printed circuit board 431 of FIG. 4) or the second printed circuit board (e.g., the second printed circuit board 432 of FIG. 4). According to an embodiment, the first flexible connection member 551 may electrically connect the first printed circuit board (e.g., the first printed circuit board 431 of FIG. 4) and the second printed circuit board (e.g., the second printed circuit board 432 of FIG. 4) through the connection ends 551a and 551b disposed at two opposite ends. According to an embodiment, the second flexible connection member 552 may also electrically connect the first printed circuit board (e.g., the first printed circuit board 431 of FIG. 4) and the second printed circuit board (e.g., the second printed circuit board 432 of FIG. 4) through the connection ends 552a and 552b disposed at two opposite ends. Here, the connection end may include a receptacle or a header having at least one pin. The first and second flexible connection members 551 and 552 may be connected to at least one of the first printed circuit board or the second printed circuit board through various other means as well as a receptacle or header structure. For example, the flexible connection members 551 and 552 may be connected to at least one of the first printed circuit board (e.g., the first printed circuit board 431 of FIG. 4) or the second printed circuit board (e.g., the second printed circuit board 432 of FIG. 4) through a bonding part formed through a hot-bar process by thermal compression. The shape of the connection end and the method of manufacturing the same are not limited to any particular embodiment. According to various embodiments, depending on the shape of the connection end, the first and second flexible connection members 551 and 552 may include, e.g., a flexible printed circuit (FPC) or flexible flat cable (FFC) type, a board-to-board (B) type connector structure, a zip type connector structure, a bonding type connector structure formed through a hot bar process, a low insertion force (LIF) connector structure, and a zero insertion force (ZIF) connector structure.

The first flexible connection member 551 may include a rigid portion 551c fixed to a side of the first housing structure (e.g., the first housing structure 310 of FIG. 4) along a length direction of the first flexible connection member 551, a rigid portion 551d fixed to a side of the second housing structure (e.g., the second housing structure 320 of FIG. 4), and a flex portion 551e disposed between the rigid portions 551c and 551d. The second flexible connection member 552 may include a rigid portion 552c fixed to a side of the first housing structure (e.g., the first housing structure 310 of FIG. 4) along a length direction of the flexible connection member 551, a rigid portion 552d fixed to a side of the second housing structure (e.g., the second housing structure 320 of FIG. 4), and a flex portion 552e disposed between the rigid portions 552c and 552d. Here, that the rigid portions 551c and 551d of the first flexible connection member 551 are fixed to the first housing structure side and the second housing structure side may include, e.g., the rigid portion 551c of the first flexible connection member 551 being fixed to a first hinge structure (e.g., the first hinge structure 441 of FIG. 4), a first printed circuit board 431, or a first bracket assembly (e.g., the first bracket assembly 423 of FIG. 4) disposed inside the first housing structure 310. Similarly, it may also include the rigid portion 551d of the first flexible connection member 551 being fixed to a second hinge structure (e.g., the second hinge structure 442 of FIG. 4), a second printed circuit board 432, or a second bracket assembly (e.g., the second bracket assembly 424 of FIG. 4) disposed inside the second housing structure 320. According to an embodiment, that the rigid portions 552c and 552d of the second flexible connection member 552 are fixed to the first housing structure side and the second housing structure side may be applied similarly to the embodiment in which the rigid portions 551c and 551d of the first flexible connection member 551 are fixed to the first housing structure side and the second housing structure side.

According to various embodiments, the first and second flexible connection members 551 and 552 may include at least one electrically conductive path connecting a first printed circuit board (e.g., the first printed circuit board 431 of FIG. 4) and a second circuit board (e.g., the first printed circuit board 432 of FIG. 4). Power or a control signal provided from a power management module or a processor may be transmitted through the conductive path. As another example, the flexible connection members 551 and 552 may include an RF line, which is a high frequency signal line, as a conductive path for transferring a communication signal provided from a wireless transceiver or a communication signal received through a communication device to the wireless transceiver. For example, the first flexible connection member 551 may include an electrical line (or a conductive path) for transmitting a communication signal including an RF signal. Further, the second flexible connection member 552 may include an electrical line for transmitting an electrical signal having a lower sensitivity to impedance change than the electrical line included in the first flexible connection member 551. For example, the second flexible connection member 552 may include a power line. According to another embodiment, the second flexible connection member 552 may include, alternatively or additionally to the power line, an electrical line for transmitting data and/or an electrical line (a conductive path) for transmitting a control signal. According to an embodiment, the first flexible connection member 551 may be formed to be thinner than the second flexible connection member 552 according to RF signal characteristics. Accordingly, when the first flexible connection member 551 including the conductive path for transmitting the RF signal is repeatedly used in the hinge space, the first flexible connection member 551 may be relatively less durable than the second flexible connection member 552, and may be vulnerable to impedance change, making it difficult to smoothly exert communication performance. When the first flexible connection member 551 is used as an electrical line for transmitting a communication signal including an RF signal, it may be limited to adjust the width or thickness thereof in order to minimize the impedance change in the high bending section.

Accordingly, according to various embodiments of the disclosure, an impedance matching part 553a or 553b may be additionally included in at least one end 551a or 551b of the first flexible connection member 551. Here, at least one end 551a or 551b of the flexible connection member 550 may correspond to a rigid portion of the flexible connection member.

Hereinafter, in describing the flexible connection member 550, the first flexible connection member 551 in which an electrical line for transmitting a communication signal including an RF signal is formed may be mainly described.

FIG. 7 is a view illustrating a flexible connection member 600 (e.g., the first flexible connection member 551 of FIG. 5) according to an embodiment of the disclosure. FIG. 8 is a view illustrating a flexible connection member 600 (e.g., the first flexible connection member 551 of FIG. 5) according to another embodiment of the disclosure. If FIGS. 5 and 6 are front views of the flexible connection member, FIGS. 7 and 8 are cross-sectional views of the flexible connection member.

Referring to FIG. 7, a flexible connection member 600 (e.g., the first flexible connection member 551 of FIG. 5) may be divided into rigid portions 601 and 603 to be fixed to a housing (e.g., the first housing structure 510 and the second housing structure 520 of FIG. 5) and a flex portion 602 disposed between the rigid portions 601 and 603 along a length direction. The rigid portions 601 and 603 may include a first rigid portion 601 and a second rigid portion 603. A first connection end (e.g., 551a of FIG. 6) may be formed in the first rigid portion 601, and a second connection end (e.g., 551b of FIG. 6) may be formed in the second rigid portion 603.

According to various embodiments, the first rigid portion 601 and the second rigid portion 603 may form the same layer and the same structure. However, without limitations thereto, the first rigid portion 601 and the second rigid portion 603 may form various arrangements and various layered structures. In the drawings, the first rigid portion 601 and the second rigid portion 603 are shown to have a symmetrical shape, but are not necessarily limited thereto. Hereinafter, the first rigid portion 601 and the flex portion 602 are described, and a description of the first rigid portion 601 will be omitted. The description of the first rigid portion 601 may be applied to the second rigid portion 603.

FIG. 7 illustrates a layered structure (or a stacked structure) of the first rigid portion 601 and the flex portion 602 including a plurality of conductive layers and insulation layers. According to various embodiments of the disclosure, the first rigid portion 601 and the flex portion 602 may include a first substrate layer 610, a first conductive layer 620, a second substrate layer 630, and a second conductive layer 640. A first adhesive layer 650 formed between the first conductive layer 620 and the second substrate layer 630 may be further included. The first substrate layer 610, the first conductive layer 620, the first adhesive layer 650, the second substrate layer 630, and the second conductive layer 640 may be sequentially stacked along the height direction. An upper surface of the second conductive layer 640 may be a portion viewed from the outside of the flexible connection member 600, and a surface (e.g., an upper surface) exposed from the first conductive layer 620 to the outside may be covered by a coverlay 690.

The first substrate layer 610 and/or the second substrate layer 630 may be a polyimide (PI)-based substrate layer, such as a flexible copper clad laminate (FCCL). As another example, the first conductive layer 620 and/or the second conductive layer 640 may be manufactured as a laminate in which a thin metal plate (e.g., copper (Cu)) is laminated on at least one surface of a polyimide (PI)-based substrate layer. The first adhesive layer 650 may be formed of, e.g., a prepreg or a dielectric adhesive including a bonding sheet. The coverlay may include a coverlay film and cover resin layers stacked on two opposite surfaces of the coverlay film. The coverlay film may be formed of an electrical insulation layer, and may be applied having excellent properties for oxidation-resistance, heat-resistance, radiation-resistance, low-temperature properties, or chemical resistance.

According to various embodiments, the flexible connection member 600 may further include a third substrate layer 660 and a third conductive layer 670. The third substrate layer 660 and the third conductive layer 670 may be stacked on the first substrate layer 610 through the second adhesive layer 680. According to various embodiments, the first rigid portion 601 and the flex portion 602 may include more conductive layers and insulation layers than those in the embodiments illustrated in the drawings. Here, some conductive layers and some insulation layers may integrally extend from the first rigid portion 601 and the flex portion 602. For example, referring to FIGS. 7 and 8, FIG. 7 illustrates an embodiment in which the first substrate layer 610 and the first conductive layer 620 are integrally extended from the first rigid portion 601 and the flex portion 602, and FIG. 8 illustrates an embodiment in which not only the first substrate layer 610 and the first conductive layer 620 but also the third substrate layer 660 and the third conductive layer 670 are integrally extended from the first rigid portion 601 and the flex portion 602. Various other embodiments are applicable.

Referring to FIGS. 7 and 8, a flexible connection member 600 according to various embodiments of the disclosure may include at least one via 621. It is generally known that vias used for electrical conduction between a conductive layer and another conductive layer in a multi-layered printed circuit board are difficult to form in a flexible printed circuit board (FPCB). In the flexible connection member 600 according to various embodiments of the disclosure, the first adhesive layer 650 is formed so that the first substrate layer 610, the first conductive layer 620, the second substrate layer 630, and the second conductive layer 640 form a laminated structure, allowing it easy to form at least one via between conductive layers.

According to various embodiments, a ground may be formed in at least a portion of the plurality of conductive layers included in the flexible connection member 600. For example, a ground may be formed on either the first conductive layer 620 or the third conductive layer 670, or the first conductive layer 620 and the third conductive layer 670 may be formed as a ground. An electrical line for transmitting a communication signal including an RF signal may be formed on the second conductive layer 640, and the first conductive layer 620 and/or the third conductive layer 670 may be formed as a ground, thereby forming a stable ground structure.

According to various embodiments, an impedance matching part 701 may be formed in the second conductive layer 640 of the first rigid unit 601. The impedance matching part 701 is, e.g., a passive element, and may be formed in the form of a packaged chip or in the form of a pattern. For example, the impedance matching part 701 may be mounted on the second conductive layer 640 in the form of a packaged chip using a surface mounted technology (SMT) technique. According to another embodiment, the impedance matching part 701 may be formed as a pattern connected to the electrical line of the second conductive layer 640.

The impedance matching part 701 may be formed on the path of the RF signal line. Referring back to FIG. 5, the electronic device (e.g., the electronic device 101 of FIG. 1) may include a plurality of flexible connection members (e.g., the first flexible connection member 551 and the second flexible connection member 552 of FIG. 5), and the impedance matching part 701 may be formed on the flexible connection member (e.g., the first flexible connection member 551) including the path of the RF signal line.

As illustrated in FIG. 7, the foldable electronic device may include an impedance matching part 702 formed on the second conductive layer 640 of the second rigid portion 603, along with the impedance matching part 701 formed on the second conductive layer 640 of the first rigid portion 601, and may thus have a bi-directional matching structure.

According to various embodiments of the disclosure, the impedance matching parts 701 and 702 may be elements that enable the impedance to be set to a predetermined value in the flexible connection member 600 (e.g., the first flexible connection member 551) including an RF signal line. For example, the overall impedance may be set to have a predesignated impedance by the impedance matching parts 701 and 702 while allowing for free design for the portion (e.g., bending portion) of the flexible connection member 600 (e.g., the first flexible connection member 551) which is difficult to form to have a predesignated impedance. For example, when the ideal impedance (hereinafter, referred to as a "predesignated impedance") of the flexible connection member 600 (e.g., the first flexible connection member 551) is set to 50 ohm, a section which is subject to frequent movement, such as a bending portion of the flexible connection member 600 (e.g., the first flexible connection member 551), may be formed to be thin or narrow regardless of the ideal impedance in order to have high flexibility. For example, the bending portion of the flexible connection member 600 (e.g., the first flexible connection member 551) may be designed to have an impedance of 100 ohm. In this case, the entire impedance of the connection member 600 (e.g., the first flexible connection member 551) may be formed to be 50 ohm by using the impedance matching parts 701 and 702. According to various embodiments of the disclosure, even if a partial section of the flexible connection member 600 (e.g., the first flexible connection member 551) for transmitting an RF signal is formed to deviate from a predetermined impedance (e.g., 50 ohm), the entire impedance of the flexible connection member 600 (e.g., the first flexible connection member 551) may be impedance-matched to the predesignated impedance as the impedance matching part is disposed at an end of the flexible connection member 600 (e.g., the first flexible connection member 551). Accordingly, it is possible to design a bending portion to have an appearance with enhanced bending performance without hampering transfer of RF signals of the flexible connection member 600 (e.g., the first flexible connection member 551).

The electronic device according to various embodiments of the disclosure may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The storage medium readable by the machine may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program products may be traded as commodities between sellers and buyers. The computer program product may be distributed in the form of a machine-readable storage medium (e.g., compact disc read only memory (CD-ROM)), or be distributed (e.g., downloaded or uploaded) online via an application store (e.g., Play Store^{™}), or between two user devices (e.g., smartphones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities. Some of the plurality of entities may be separately disposed in different components. According to various embodiments, one or more of the above-described components may be omitted, or one or more other components may be added. Alternatively or Further, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

According to various embodiments of the disclosure, there may be provided a foldable electronic device (e.g., the foldable electronic device 101 of FIG. 2), comprising a hinge structure (e.g., the hinge structure 440 of FIG. 4), a foldable housing (e.g., the foldable housing 300 of FIG. 2) including a folding area where the electronic device is substantially folded about a folding axis, wherein the foldable housing includes a first housing structure (e.g., the first housing structure 310 of FIG. 2) connected to the hinge structure and including a first surface facing in a first direction, a second surface facing in a second direction opposite to the first direction, and a first printed circuit board where a plurality of electronic components are mounted and a second housing structure (e.g., the second housing structure 320 of FIG. 2) connected to the hinge structure, including a third surface facing in a third direction, a fourth surface facing in a fourth direction opposite to the third direction, and a second printed circuit board where a plurality of electronic components are mounted, and configured to be folded with respect to the first housing structure, a flexible display (e.g., the display 200 of FIG. 2) disposed in the foldable housing and extending from the first surface of the first housing structure to the third surface of the second housing structure, and a flexible connection member (e.g., the flexible connection member 600 of FIG. 7) lying across at least a portion of an inside of the first housing structure, electrically connecting the first printed circuit board and the second printed circuit board through connection ends disposed at two opposite ends thereof, and including an electrical line configured to transmit a communication signal including a radio frequency (RF) signal, wherein an impedance matching part (e.g., the impedance matching part 701 and/or 702 of FIG. 7) is disposed at at least one end of the flexible connection member.

According to various embodiments, impedance matching parts may be formed at two opposite ends of the flexible connection member.

According to various embodiments, the flexible connection member includes a flexible printed circuit board (FPCB).

According to various embodiments, the flexible connection member may include at least one rigid portion to be fixed to at least one of the first housing structure and the second housing structure along a length direction of the connection member and a flex portion disposed adjacent to the at least one rigid portion.

According to various embodiments, the flex portion may be disposed in a space inside the hinge structure.

According to various embodiments, the impedance matching part may be formed in the rigid portion.

According to various embodiments, the flexible connection member may include a first substrate layer and a first conductive layer formed on the first substrate layer.

According to various embodiments, the flexible connection member may include a second substrate layer formed on the first conductive layer and a second conductive layer formed on the second substrate layer.

According to various embodiments, a via formed between the first conductive layer and the second conductive layer may be included.

According to various embodiments, the impedance matching part may have a packaged chip form or a patterned circuit form.

According to various embodiments of the disclosure, there may be provided a flexible connection member (e.g., the flexible connection member 600 of FIG. 7) comprising a first substrate layer (e.g., the first substrate layer 610 of FIG. 7), a first conductive layer (e.g., the first conductive layer 620 of FIG. 7) contacting one surface of the first substrate layer, a second substrate layer (e.g., the second substrate layer 630 of FIG. 7) formed on the first conductive layer, and a second conductive layer (e.g., the second conductive layer 640 of FIG. 7) contacting the second substrate layer and including an RF line, wherein an impedance matching part (e.g., the impedance matching part 701 and/or 702 of FIG. 7) is mounted, in a packaged chip form or a patterned circuit form, on the second conductive layer.

According to various embodiments, the flexible connection member may include at least one rigid portion (e.g., the rigid portion 601 and/or 603 of FIG. 7) and a flex portion (e.g., the flex portion 602 of FIG. 7) disposed adjacent to the at least one rigid portion.

According to various embodiments, at least one of the first substrate layer, the first conductive layer, the second substrate layer, and the second conductive layer may form a stacked structure of the at least one rigid portion. The first substrate layer and the first conductive layer may form a stacked structure of the flex portion.

According to various embodiments, the flexible connection member may further comprise a first adhesive layer (e.g., the first adhesive layer 650 of FIG. 7) between the first conductive layer and the second substrate layer.

According to various embodiments, the flexible connection member may further comprise a coverlay (e.g., the coverlay 690 of FIG. 7) configured to protect at least a portion of the first conductive layer.

According to various embodiments of the disclosure, there may be provided a foldable electronic device, comprising a hinge structure, a foldable housing including a folding area where the electronic device is substantially folded about a folding axis, wherein the foldable housing includes a first housing structure connected to the hinge structure and including a first surface facing in a first direction, a second surface facing in a second direction opposite to the first direction, and a first printed circuit board where a plurality of electronic components are mounted and a second housing structure connected to the hinge structure and including a third surface facing in a third direction, a fourth surface facing in a fourth direction opposite to the third direction, and a second printed circuit board where a plurality of electronic components are mounted, a flexible display disposed in the foldable housing and extending from the first surface of the first housing structure to the third surface of the second housing structure, and a first flexible connection member lying across at least a portion of an inside of the first housing structure and at least a portion of an inside of the second housing structure, electrically connecting the first printed circuit board and the second printed circuit board through connection ends disposed at two opposite ends thereof, and including rigid portions to be fixed to the first housing structure and the second housing structure, respectively, and a flex portion disposed between the rigid portions and movable in a space inside the hinge structure, and including an electrical line configured to transmit a communication signal including a radio frequency (RF) signal, and a second flexible connection member including a power line, wherein an impedance matching part for adjusting impedance of the first flexible connection member to a predesignated value is disposed in the rigid portions of two opposite ends of the first flexible connection member.

According to various embodiments, the flexible connection member may include a first substrate layer and a first conductive layer formed on the first substrate layer.

According to various embodiments, the flexible connection member may include a second substrate layer formed on the first conductive layer and a second conductive layer formed on the second substrate layer.

According to various embodiments, a via formed between the first conductive layer and the second conductive layer may be included.

According to various embodiments, the impedance matching part may have a packaged chip form or a patterned circuit form.

It is apparent to one of ordinary skill in the art that the foldable electronic device according to various embodiments of the disclosure as described above are not limited to the above-described embodiments and those shown in the drawings, and various changes, modifications, or alterations may be made thereto without departing from the scope of the present invention.

## Claims

1. A foldable electronic device, comprising:
a hinge structure;
a foldable housing including a folding area where the electronic device is substantially folded about a folding axis,
wherein the foldable housing includes:
a first housing structure connected to the hinge structure and including a first surface facing in a first direction, a second surface facing in a second direction opposite to the first direction, and a first printed circuit board where a plurality of electronic components are mounted;
a second housing structure connected to the hinge structure, including a third surface facing in a third direction, a fourth surface facing in a fourth direction opposite to the third direction, and a second printed circuit board where a plurality of electronic components are mounted, and configured to be folded with the first housing structure about the hinge structure;
a flexible display disposed in the foldable housing and extending from the first surface of the first housing structure to the third surface of the second housing structure; and
a flexible connection member lying across at least a portion of an inside of the first housing structure, electrically connecting the first printed circuit board and the second printed circuit board through connection ends disposed at two opposite ends thereof, and including an electrical line configured to transmit a communication signal including a radio frequency (RF) signal,
wherein an impedance matching part is disposed at at least one end of the flexible connection member.

2. The foldable electronic device of claim 1, wherein impedance matching parts are formed at two opposite ends of the flexible connection member.

3. **The connection member of claim 1, wherein** the flexible connection member includes a flexible printed circuit board (FPCB).

4. The foldable electronic device of claim 3, wherein the flexible connection member includes at least one rigid portion to be fixed to at least one of the first housing structure and the second housing structure along a length direction of the connection member and a flex portion disposed adjacent to the at least one rigid portion.

5. The foldable electronic device of claim 4, wherein the flex portion is disposed in a space inside the hinge structure.

6. The foldable electronic device of claim 4, wherein the impedance matching part is formed in the rigid portion.

7. The foldable electronic device of claim 1, wherein the flexible connection member includes:
a first substrate layer; and
a first conductive layer formed on the first substrate layer.

8. The foldable electronic device of claim 7, wherein the flexible connection member includes:
a second substrate layer formed on the first conductive layer; and
a second conductive layer formed on the second substrate layer.

9. The foldable electronic device of claim 8, further comprising a via formed between the first conductive layer and the second conductive layer.

10. The foldable electronic device of claim 1, wherein the impedance matching part has a packaged chip form or a patterned circuit form.

11. A flexible connection member, comprising:
a first substrate layer;
a first conductive layer contacting one surface of the first substrate layer;
a second substrate layer formed on the first conductive layer; and
a second conductive layer contacting the second substrate layer and including an RF line,
wherein an impedance matching part is mounted, in a packaged chip form or a patterned circuit form, on the second conductive layer.

12. The flexible connection member of claim 11, wherein the flexible connection member includes at least one rigid portion and a flex portion disposed adjacent to the at least one rigid portion.

13. The flexible connection member of claim 12, wherein at least one of the first substrate layer, the first conductive layer, the second substrate layer, and the second conductive layer form a stacked structure of the at least one rigid portion, and
wherein the first substrate layer and the first conductive layer form a stacked structure of the flex portion.

14. The flexible connection member of claim 11, further comprising a first adhesive layer between the first conductive layer and the second substrate layer.

15. The flexible connection member of claim 11, further comprising a coverlay configured to protect at least a portion of the first conductive layer.
